(19) **Europäisches Patentamt / European Patent Office / Office européen des brevets**

(11) **EP 3 699 967 B1**

(12) **FASCICULE DE BREVET EUROPEEN**

(45) Date de publication et mention de la délivrance du brevet:
**16.11.2022 Bulletin 2022/46**

(21) Numéro de dépôt: **20157870.5**

(22) Date de dépôt: **18.02.2020**

(51) Classification Internationale des Brevets (IPC):
**H01L 33/46** (2010.01)   **H01L 33/50** (2010.01)
**H01L 25/075** (2006.01)

(52) Classification Coopérative des Brevets (CPC):
**H01L 33/465; H01L 33/50;** H01L 25/0753

(54) **DIODE ELECTROLUMINESCENTE, PIXEL COMPORTANT UNE PLURALITE DE DIODES ELECTROLUMINESCENTES ET PROCEDES DE FABRICATION ASSOCIES**

LEUCHTDIODE, PIXEL, DER EINE VIELZAHL VON LEUCHTDIODEN UMFASST, UND ENTSPRECHENDE HERSTELLUNGSVERFAHREN

LIGHT-EMITTING DIODE, PIXEL COMPRISING A PLURALITY OF LIGHT-EMITTING DIODES AND ASSOCIATED MANUFACTURING METHODS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **22.02.2019 FR 1901843**

(43) Date de publication de la demande:
**26.08.2020 Bulletin 2020/35**

(73) Titulaire: **Commissariat à l'Energie Atomique et aux Energies Alternatives**
**75015 Paris (FR)**

(72) Inventeurs:
• **LE BLEVENNEC, Gilles**
  **38054 GRENOBLE CEDEX 09 (FR)**
• **BEN BAKIR, Badhise**
  **38054 GRENOBLE CEDEX 09 (FR)**

(74) Mandataire: **Cabinet Camus Lebkiri**
**25 rue de Maubeuge**
**75009 Paris (FR)**

(56) Documents cités:
**EP-A2- 2 750 208    US-A1- 2017 250 318**

**Description**

## DOMAINE TECHNIQUE

La présente invention est relative à une diode électroluminescente, à un pixel comportant une pluralité de diodes électroluminescentes et à leurs procédés de fabrication.

## ÉTAT DE LA TECHNIQUE

D'une manière générale, un paramètre crucial notamment pour les dispositifs d'affichage est d'avoir le « gamut » le plus grand possible. En synthèse des couleurs, qu'elle soit additive ou soustractive, le gamut ou gamme de couleurs est la partie de l'ensemble des couleurs qu'un certain type de matériel permet de reproduire. Par ailleurs, les dispositifs d'éclairage et d'affichage évoluent continuellement en augmentant les flux lumineux et la définition des surfaces émissives. Pour les écrans par exemple, cela se traduit par le passage des tubes cathodiques aux écrans à cristaux liquides et désormais aux écrans OLED (de l'anglais « Organic Light-Emitting Diode »). Pour l'éclairage, il s'agit par exemple du passage de l'ampoule à incandescence à la LED (de l'anglais « Light-Emitting Diode »).

L'utilisation d'une matrice de LED à des fins d'affichage ou d'éclairage (par exemple, pour les phares dans l'industrie automobile) requiert d'adapter la technologie des LED à semiconducteurs, par exemple en nitrure de gallium GaN, à une émission matricielle pixellisée. La technologie des semiconducteurs permet en effet la fabrication de matrices avec des pixels allant d'un micromètre à quelques dizaines de micromètres. Mais le nitrure de gallium GaN par exemple n'émet que de la lumière bleue, dans la gamme de longueur d'onde de 460 nm.

Pour obtenir d'autres couleurs, il faut réaliser une opération de conversion de lumière à l'échelle du pixel. Comme la lumière bleue est la plus énergétique du spectre visible, elle peut être convertie par photoluminescence en une lumière verte ou rouge moins énergétique. La photoluminescence est un processus par lequel une substance s'excite en absorbant des photons, puis se désexcite en réémettant des photons de plus faible énergie. La photoluminescence recouvre deux formes : fluorescence et phosphorescence. La fluorescence est une photoluminescence rapide tandis que la phosphorescence est une photoluminescence lente : c'est la fluorescence qui convient aux applications d'affichage et d'éclairage. Elle est obtenue au moyen de fluorophores, qui peuvent se présenter sous forme de poudres associées à une matrice polymère.

Pour pouvoir être confinés dans des pixels de quelques microns, les fluorophores doivent être de dimensions submicroniques. Les matériaux actuellement disponibles sont des boîtes quantiques 3D (« quantum dots » en anglais) de semiconducteurs tels que le séléniure de cadmium CdSe, le phosphure d'indium InP ou le sulfure d'argent et d'indium $AgInS_2$, ou des nanophosphores d'oxyde, tel que du YAG:Ce (grenat d'yttrium et d'aluminium dopé au cérium), de sulfure ou de fluorure.

Dans le même temps, pour émettre une couleur saturée, il faut un spectre par couleur le plus étroit possible. Un spectre suffisamment étroit peut être réalisé par les boîtes quantiques 3D mais pas par les nanophosphores, qui ont des spectres d'émission large bande, aux alentours de 100 nm.

Les boîtes quantiques 3D permettent d'obtenir un spectre par couleur suffisamment étroit mais elles souffrent d'un manque de stabilité (quelques heures seulement) lorsqu'elles sont soumises à un flux de lumière ou de chaleur, ce qui est le cas dans les dispositifs d'affichage ou d'éclairage. Des solutions d'encapsulation existent mais qui ne permettent qu'une faible luminosité et une faible résolution.

Par ailleurs, une contrainte de la photo-conversion appliquée à des micropixels est l'épaisseur supplémentaire qu'elle requiert, qui pour des raisons techniques, de facteur de forme notamment, doit rester de l'ordre de la taille des pixels : pour des pixels de 3 μm par exemple, l'épaisseur de conversion doit rester de l'ordre de 3 μm maximum ; ou de 10 μm maximum pour des pixels de 10 μm. Indépendamment de la taille des pixels, le tableau 1 ci-dessous montre l'épaisseur de conversion requise pour absorber la lumière bleue à 460 nm, respectivement pour une boîte quantique 3D de phosphure d'indium ou de séléniure de cadmium CdSe ou pour un nanophosphore LuAG:Ce (grenat d'aluminium de Lutetium dopé au cérium), et pour différents taux de charge volumique en fluorophore dans le composite. Le tableau 2 ci-dessous montre quant à lui le pourcentage d'absorption atteint pour les différents fluorophores et taux de charge du tableau 1.

[Tableau 1]

| Taux de charge volumique (%) | InP | CdSe | LuAG:Ce |
|:---:|:---:|:---:|:---:|
| 10 | 8 μm | 5 μm | 150 μm |
| 20 | 3 μm | 2,5 μm | 90 μm |
| 30 | 1,2 μm | 1,2 μm | 50 μm |

[Tableau 2]

| Taux de charge volumique (%) | InP | CdSe | LuAG:Ce |
|---|---|---|---|
| 10 | 96 | 94 | 94 |
| 20 | 98 | 96 | 95 |
| 30 | 99 | 97 | 95 |

D'une manière générale, les nanophosphores comme le LuAG:Ce requièrent une épaisseur de conversion de plusieurs dizaines de microns pour absorber le bleu en totalité ou quasi-totalité, ce qui n'est pas compatible avec des tailles de pixels inférieures à 10 $\mu$m.

Le document US 2017/0250318 décrit un écran comprenant plusieurs pixels en couleurs. Chaque pixel comprend trois dispositifs élémentaires d'émission de lumière destinés respectivement à émettre de la lumière rouge, verte et bleue. Chacun de ces dispositifs d'émission comprend une LED pompée électriquement et configurée pour émettre dans l'ultraviolet, et, au-dessus de cette LED, une couche de conversion par photoluminescence réalisée au moyen de phosphores rouges, verts ou bleus noyés dans une matrice de silice. Chaque couche de conversion est entourée et délimitée latéralement par une paroi en résine absorbante noire, éventuellement recouverte d'une couche réfléchissante en métal. On connaît aussi du document EP 2750208 un dispositif d'émission de lumière comprenant une LED UV et, au-dessus de cette LED, une couche de conversion de longueur d'onde réalisée au moyen de phosphores blancs, bleus, verts ou rouges. Dans ce dispositif, un filtre multicouche, qui transmet le rayonnement UV en question mais qui réfléchit le rayonnement visible obtenu par conversion, est intercalé entre la LED et la couche de conversion. Par ailleurs, un autre filtre multicouche, cette fois réfléchissant pour le rayonnement UV tandis qu'il transmet le rayonnement visible obtenu par conversion, est disposé au-dessus de la couche de conversion, à l'opposé de la LED.

L'article « Resonant-cavity light-emitting diodes : a review », de Roel G. Baets et al., Proc. of SPIE, Vol. 4996, 2003, décrit le principe d'une diode électroluminescente à cavité résonante : la couche active d'une diode électroluminescente au nitrure de gallium est confinée dans une cavité Fabry-Perot résonante afin d'améliorer l'efficacité d'extraction.

Plus récemment, l'article « Monolithic red/green/blue micro-LEDs with HBR and DBR structures », de Guan-Syun Chen et al., IEEE Photonics Technology Letters, Vol. 30, No. 3, 1er février 2018, décrit un pixel comportant trois diodes électroluminescentes au nitrure de gallium : une première sans couche de conversion pour l'émission de lumière bleue, une deuxième avec couche de conversion pour l'émission de lumière rouge et une troisième avec couche de conversion pour l'émission de lumière verte. Les fluorophores utilisés sont des boîtes quantiques 3D. Les trois diodes sont séparées les unes des autres au niveau de leur couche active, et au niveau de leur couche de conversion le cas échéant, par une couche absorbant le rayonnement lumineux, afin de limiter la diaphonie (« crosstalk » en anglais) pour améliorer la pureté et le contraste des couleurs. Un miroir de Bragg inférieur, agencé sous le substrat, est configuré pour réfléchir les trois couleurs. Un miroir de Bragg supérieur est agencé sur les couches de conversion des deuxième et troisième diodes afin de bloquer la lumière bleue et améliorer encore la pureté des lumières rouge et verte extraites. Le pixel obtenu est de dimensions 30 $\mu$m par 30 $\mu$m.

## RÉSUMÉ DE L'INVENTION

On constate qu'il existe un besoin de disposer d'un dispositif optoélectronique permettant d'obtenir un rayonnement d'une couleur saturée et différente du bleue, tout en étant de dimensions microniques. Il existe également un besoin de disposer d'un pixel de dimensions microniques comportant plusieurs dispositifs optoélectroniques permettant chacun d'obtenir un rayonnement d'une couleur différente et saturée, y compris le bleu.

L'invention a notamment pour objet un dispositif optoélectronique comportant :

- une LED adaptée à l'émission d'un rayonnement, la LED comportant une couche active,

- et une couche de conversion s'étendant au-dessus de la couche active de la LED et comportant une pluralité de fluorophores adaptés à la conversion du rayonnement émis par la LED,

la couche de conversion étant confinée latéralement par un miroir réfléchissant à la fois le rayonnement converti par les fluorophores et le rayonnement non converti par les fluorophores, et verticalement entre des premier et second filtres réfléchissants multicouches formant une cavité Fabry-Perot résonante, qui bloque le rayonnement non converti par les fluorophores et qui a un pic de transmittance pour le rayonnement converti par les fluorophores.

Le dispositif selon l'invention peut également présenter une ou plusieurs des caractéristiques ci-dessous, considérées individuellement ou selon toutes les combinaisons techniquement possibles :

Les fluorophores sont des nanophosphores ;

Les nanophosphores sont choisis parmi $SrSi_2O_2N_2:Eu^{2+}$ ; $\beta$-SIALON ; $Y_3Al_5O_{12}:Ce^{3+}$ ; LuAG:Ce ; $LuYAlMgSiO_3:Ce$ ; $SrSi_5N_8:Eu^{2+}$ ; $(BaSr)_2Si_5N_8:Eu^{2+}$ ; $(Ca, Sr)AlSiN_3:Eu^{2+}$ ; $Sr[LiAl_3N_4]:Eu^{2+}$ ; $Sr[Mg_3SiN_4]:Eu^{2+}$; $Sr_{1-x}Ca_xS:Eu^{2+}$ ;

Les fluorophores sont des boîtes quantiques 3D ;

Les boîtes quantiques 3D sont choisies parmi : ZnS ; ZnSe ; CdS ; CdSe ; CdZnSe ; CdTe ; PbS ; InP ; $CuInS_2$ ; $CuGaS_2$ ; $CuInSe_2$ ; $CuGaSe_2$ ; $CuInGaSe_2$ ; CuSe ; InSe ; GaSe ou toute combinaison des alliages précédents ;

Le rayonnement converti par les fluorophores est extrait de la cavité Fabry-Perot résonante par l'un des premier ou second filtres réfléchissants multicouches, dit « filtre d'extraction », et en ce que ledit filtre d'extraction comporte un réseau d'extraction du rayonnement converti par les fluorophores ;

Le premier filtre réfléchissant multicouche s'étend entre la couche active et la couche de conversion tandis que le second filtre réfléchissant multicouche s'étend au-dessus de la couche de conversion, et le second filtre réfléchissant multicouche a une réflectivité supérieure à 30% pour le rayonnement converti par les fluorophores.

L'invention a également pour objet un pixel comportant des premier et deuxième dispositifs optoélectroniques selon l'invention, le premier dispositif optoélectronique comportant une première LED et le deuxième dispositif optoélectronique (110R) comportant une deuxième LED, le rayonnement converti par les fluorophores de la deuxième LED étant distinct du rayonnement converti par les fluorophores de la première LED.

Le pixel selon l'invention peut également présenter une ou plusieurs des caractéristiques ci-dessous, considérées individuellement ou selon toutes les combinaisons techniquement possibles :

Le pixel comporte en outre une troisième LED pour l'émission d'un rayonnement distinct des rayonnements convertis par les fluorophores des premier et deuxième dispositifs optoélectroniques.

La troisième LED présente une couche active confinée latéralement par un miroir et verticalement entre des premier et second filtres réfléchissants multicouches formant une cavité Fabry-Perot résonante ayant un pic de transmittance pour le rayonnement émis par la couche active.

Le rayonnement émis par la couche active est extrait de la cavité Fabry-Perot résonante par l'un des premier ou filtres réfléchissants multicouches, dit « filtre d'extraction », et en ce que ledit filtre d'extraction comporte un réseau d'extraction du rayonnement émis par la couche active.

La présente invention a également pour objet un procédé de fabrication d'un dispositif optoélectronique selon l'invention, comportant les étapes suivantes :

- réaliser une LED comportant une couche active ;

- réaliser un premier filtre réfléchissant multicouche au-dessus de la couche active ;

- réaliser une couche de conversion comportant une pluralité de fluorophores, configurée pour convertir par fluorescence un rayonnement émis par la couche active ;

- réaliser un second filtre réfléchissant multicouche, de manière que la couche de conversion soit confinée verticalement entre les premier et second filtres réfléchissants multicouches, les premier et second filtres réfléchissants multicouches formant une cavité Fabry-Perot résonante, bloquant un rayonnement non converti par les fluorophores et ayant un pic de transmittance pour le rayonnement converti par les fluorophores ;

- réaliser autour de la couche de conversion un miroir réfléchissant à la fois le rayonnement converti par les fluorophores et le rayonnement non converti par les fluorophores, de manière à confiner latéralement la couche de conversion.

L'invention a également pour objet un procédé de fabrication d'un pixel selon l'invention, comportant les étapes suivantes :

- réaliser des première et deuxième LED comportant chacune une couche active;
- réaliser un premier filtre réfléchissant multicouche, adapté à un premier rayonnement, au-dessus de la couche active de la première LED ;
- réaliser un premier filtre réfléchissant multicouche, adapté à un deuxième rayonnement distinct du premier rayonnement, au-dessus de la couche active de la deuxième LED ;
- réaliser une première couche de conversion comportant une pluralité de premiers fluorophores, configurée pour convertir par fluorescence un rayonnement émis par la couche active de la première LED de manière à obtenir le premier rayonnement ;

- réaliser une deuxième couche de conversion comportant une pluralité de deuxièmes fluorophores, configurée pour convertir par fluorescence un rayonnement émis par la couche active de la deuxième LED de manière à obtenir le deuxième rayonnement ;
- réaliser un second filtre réfléchissant multicouche, adapté au premier rayonnement, de manière que la première couche de conversion soit confinée verticalement entre les premier et second filtres réfléchissants multicouches adaptés au premier rayonnement et formant une cavité Fabry-Perot résonante, bloquant un rayonnement non converti par les premiers fluorophores et ayant un pic de transmittance pour le premier rayonnement ;
- réaliser un second filtre réfléchissant multicouche, adapté au deuxième rayonnement, de manière que la deuxième couche de conversion soit confinée verticalement entre les premier et second filtres réfléchissants multicouches adaptés au deuxième rayonnement et formant une cavité Fabry-Perot résonante, bloquant un rayonnement non converti par les deuxième fluorophores et ayant un pic de transmittance pour le deuxième rayonnement ;
- réaliser autour des première et deuxième couches de conversion un miroir réfléchissant à la fois les premier et deuxième rayonnements et le rayonnement non converti par les premiers et deuxièmes fluorophores, de manière à confiner latéralement les première et deuxième couches de conversion.

## BRÈVE DESCRIPTION DES FIGURES

D'autres caractéristiques et avantages de l'invention ressortiront clairement de la description qui en est donnée ci-dessous, à titre indicatif et nullement limitatif, en référence aux figures annexées, parmi lesquelles :

La figure 1 montre schématiquement une vue en coupe d'un pixel comportant une pluralité de dispositifs optoélectroniques selon un mode de réalisation de l'invention.

La figure 2a montre schématiquement une vue en coupe d'un dispositif optoélectronique selon un premier mode de réalisation de l'invention.

La figure 2b montre schématiquement une vue de dessus du dispositif optoélectronique de la figure 2a.

La figure 3a montre schématiquement une vue en coupe d'un dispositif optoélectronique selon un deuxième mode de réalisation de l'invention.

La figure 3b montre schématiquement une vue de dessus d'un dispositif optoélectronique selon une première variante du mode de réalisation de la figure 3a.

La figure 3c montre schématiquement une vue de dessus d'un dispositif optoélectronique selon une deuxième variante du mode de réalisation de la figure 3a.

La figure 4a montre schématiquement un premier exemple de la deuxième variante de la figure 3c.

La figure 4b montre schématiquement un deuxième exemple de la deuxième variante de la figure 3c.

La figure 5a montre schématiquement une première étape d'un procédé de fabrication d'un pixel comportant plusieurs dispositifs optoélectroniques selon l'invention.

La figure 5b montre schématiquement une deuxième étape d'un procédé de fabrication d'un pixel comportant plusieurs dispositifs optoélectroniques selon l'invention.

La figure 5c montre schématiquement une troisième étape d'un procédé de fabrication d'un pixel comportant plusieurs dispositifs optoélectroniques selon l'invention.

La figure 5d montre schématiquement une quatrième étape d'un procédé de fabrication d'un pixel comportant plusieurs dispositifs optoélectroniques selon l'invention.

La figure 5e montre schématiquement une cinquième étape d'un procédé de fabrication d'un pixel comportant plusieurs dispositifs optoélectroniques selon l'invention.

La figure 5f montre schématiquement une sixième étape d'un procédé de fabrication d'un pixel comportant plusieurs dispositifs optoélectroniques selon l'invention.

Pour plus de clarté, les éléments identiques ou similaires sont repérés par des signes de référence identiques sur l'ensemble des figures.

## DESCRIPTION DÉTAILLÉE D'AU MOINS UN MODE DE RÉALISATION

Dans le cadre du présent document, on emploie indifféremment les termes « diode électroluminescente », « DEL » et « LED » (de l'anglais « light-emitting diode »).

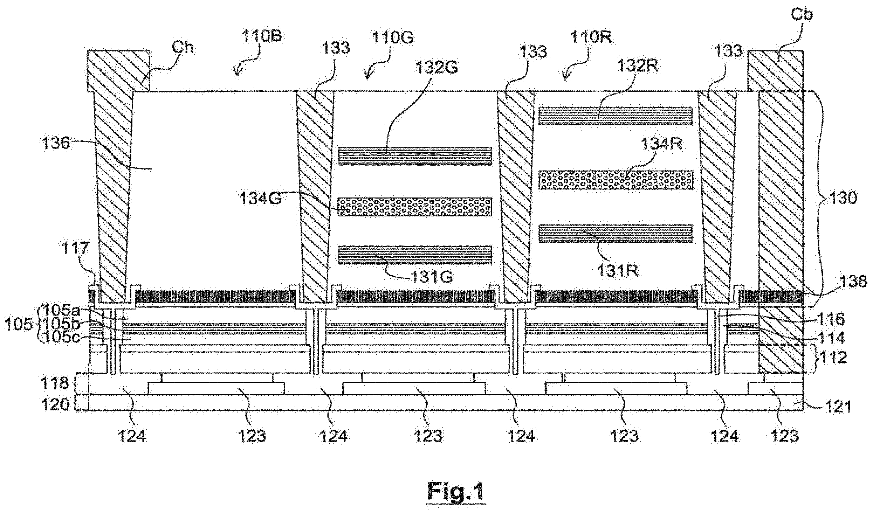

La figure 1 montre schématiquement une vue en coupe d'un pixel, comportant :

- des premier et deuxième dispositifs optoélectroniques 110G, 110R selon un premier mode de réalisation de l'invention, le premier dispositif optoélectronique 110G comportant une première LED et le deuxième dispositif optoélectronique 110R comportant une deuxième LED ; et

- une troisième LED 110B.

Chacune des première, deuxième et troisième LED comporte généralement un empilement actif 105, agencé sur un empilement d'interconnexion 118, lui-même agencé sur un circuit intégré de contrôle 120. Les premier et deuxième dispositifs optoélectroniques 110G, 110R selon le premier mode de réalisation de l'invention comportent en outre un empilement de conversion 130 agencé sur l'empilement actif, ou hétérostructure, 105.

L'empilement actif 105 comprend par exemple, dans cet ordre : une couche 105a de nitrure de gallium dopé de type N, une couche 105b émissive, une couche 105c de nitrure de gallium dopé de type P et une couche 112 métallique de contact d'anode. La couche émissive 105b est par exemple constituée par un empilement d'une ou plusieurs couches émissives formant chacune un puit quantique, par exemple à base de GaN, InP, InGaN, AlGaN, AlN, AlInGaN, GaP, AlGaP ou AlInGaP, et étant chacune disposée entre deux couches barrières, par exemple à base de GaN. L'empilement actif 105 est adapté, lorsqu'un courant est appliqué entre sa région d'anode, formée par la couche 105c, et sa région de cathode, formée par la couche 105a, à émettre de la lumière dans une bande de longueurs d'ondes déterminée, par exemple de largeur à mi-hauteur inférieure à 100 nm, fonction de la nature de la couche émissive 105b. L'empilement 105 est typiquement adapté pour émettre de la lumière bleue. En effet, l'invention trouve une application particulièrement avantageuse dans la conversion de lumière bleue. Mais d'une manière générale, l'empilement 105 est adapté pour émettre de la lumière visible, c'est-à-dire de longueur d'onde typiquement comprise entre 380 nm et 700nm, préférentiellement de la lumière bleue. L'empilement 105 est ainsi généralement réalisé à base de matériaux semi-conducteur III-V, c'est-à-dire comprenant un élément de la colonne V du tableau périodique des éléments, par exemple de l'azote N ou du phosphore P, associé à un ou plusieurs éléments de la colonne III du tableau périodique des éléments, par exemple du gallium Ga, de l'aluminium Al et/ou de l'indium In. Des exemples de matériaux semi-conducteurs III-V sont ainsi le nitrure de gallium GaN, le nitrure d'indium InN, le nitrure d'aluminium AlN, le phosphure de gallium GaP, le phosphure d'indium InP, le nitrure d'indium-gallium InGaN, le nitrure d'aluminium-gallium AlGaN, le nitrure d'indium-gallium InGaN, le phosphure d'aluminium-gallium AlGaP, le phosphure d'aluminium-indium-gallium AlInGaP, le nitrure d'indium-gallium-aluminium InGaAlN.

Un exemple d'architecture LED est à présent décrit. Dans cet exemple, des tranchées sensiblement verticales sont formées dans l'empilement 105, depuis la couche 112, pour délimiter une pluralité d'îlots ou mesas correspondant aux différentes LED du pixel. Dans l'exemple représenté, ces tranchées traversent entièrement les couches 112, 105c, 105b et 105a de l'empilement. Les parois latérales des tranchées sont revêtues d'une couche isolante 114 et les tranchées sont remplies d'un métal 116 ayant une fonction de miroir. Un élément 117 de reprise de contact est réalisé au contact du métal 116 de chaque tranchée.

L'empilement d'interconnexion 118 comporte typiquement une ou plusieurs couches isolantes, une ou plusieurs couches métalliques, et un ou plusieurs niveaux de vias conducteurs. Dans l'exemple représenté, l'empilement d'interconnexion 118 comprend, pour chaque LED, une plaque métallique de connexion à un dispositif extérieur, connectée de façon individuelle à l'électrode d'anode 112 de la LED de façon à pouvoir commander individuellement le courant circulant dans la LED et/ou une tension appliquée aux bornes de la LED au moyen d'un dispositif extérieur.

Le circuit intégré de contrôle 120 est typiquement formé dans et sur un substrat semiconducteur 121, par exemple un substrat en silicium. Dans l'exemple représenté, le circuit de contrôle 120 comporte sur une de ses faces, pour chaque LED, un plot métallique de connexion 123 destiné à être connecté à l'électrode d'anode 112 de la LED de façon à pouvoir commander un courant circulant dans la LED et/ou une tension appliquée à la LED. Le circuit de contrôle 120 comprend par exemple, pour chaque LED, une cellule élémentaire de contrôle (non détaillée), connectée au plot métallique 123 dédié à la LED et comportant un ou plusieurs transistors, permettant de contrôler le courant circulant dans la LED et/ou la tension appliquée à la LED. Le circuit de contrôle 120 est par exemple réalisé en technologie CMOS. Les plots métalliques 123 peuvent être entourés latéralement par un matériau isolant 124, par exemple de l'oxyde de silicium, de façon que le circuit de contrôle 120 présente une surface, en contact avec l'empilement d'interconnexion 118, qui est sensiblement plane et comprend une alternance de régions métalliques 123 et de régions isolantes 124.

L'exemple d'architecture LED qui vient d'être décrit n'est pas limitatif et d'une manière générale, tout type d'architecture LED et notamment tout système de contactage est envisageable. Le cas d'un pixel comportant des premier et deuxième dispositifs optoélectroniques selon l'invention, ainsi qu'une troisième LED, vient d'être décrit, toutefois chacun des premier et deuxième dispositifs optoélectroniques peut être considéré individuellement, en tant que tel.

D'une manière générale, l'empilement de conversion 130 de chaque dispositif optoélectronique comporte de préférence une couche 138 texturée, par exemple en semiconducteur gravé, la couche 138 étant déposée sur l'architecture de LED et permettant d'améliorer l'extraction des photons émis par l'empilement 105. Pour le premier dispositif optoélectronique 110G, l'empilement de conversion 130 comporte une première couche de conversion 134G, qui comprend une pluralité de premiers fluorophores permettant de convertir par fluorescence un rayonnement émis par la couche active 105 de la première LED en un premier rayonnement distinct. D'une manière générale, le rayonnement émis par la couche active 105 est également appelé « rayonnement de pompe » ; de même la longueur d'onde du rayonnement émis par la couche active 105 est également appelée « longueur d'onde de pompe ». La première couche de conversion 134G est confinée verticalement entre des premier et second filtres réfléchissants multicouches 131G, 132G adaptés audit premier rayonnement. Les premier et second filtres réfléchissants multicouches 131G, 132G forment une première cavité Fabry-Perot résonante qui bloque un rayonnement non converti par les premiers fluorophores et présente au contraire un pic de transmittance pour le premier rayonnement. Le premier rayonnement est extrait de la première cavité par l'un des premier ou second filtres réfléchissants multicouches 131G, 132G, plus précisément par le filtre réfléchissant multicouche le plus éloigné de la couche active 105, en l'occurrence le second filtre réfléchissant multicouche 132G, dit également « filtre d'extraction ». La première couche de conversion 134G présente avantageusement une épaisseur minimale de $\lambda_1/2n_1$, avec $\lambda_1$ la longueur d'onde du premier rayonnement et $n_1$ l'indice optique de la première couche de conversion 134G, pour une meilleure efficacité de conversion.

De manière analogue, pour le deuxième dispositif optoélectronique 110R, l'empilement de conversion 130 comporte une deuxième couche de conversion 134R, qui comprend une pluralité de deuxièmes fluorophores permettant de convertir par fluorescence un rayonnement émis par la couche active 105 de la deuxième LED, ou rayonnement de pompe, en un deuxième rayonnement distinct. La deuxième couche de conversion 134R est confinée verticalement entre des premier et second filtres réfléchissants multicouches 131R, 132R adaptés audit deuxième rayonnement. Les premier et second filtres réfléchissants multicouches 131R, 132R forment une deuxième cavité Fabry-Perot résonante qui bloque un rayonnement non converti par les premiers fluorophores et présente au contraire un pic de transmittance pour le deuxième rayonnement. Le deuxième rayonnement est extrait de la deuxième cavité par l'un des premier ou second filtres réfléchissants multicouches 131R, 132R, plus précisément par le filtre réfléchissant multicouche le plus éloigné de la couche active 105, en l'occurrence le second filtre réfléchissant multicouche 132R, dit également « filtre d'extraction ». La deuxième couche de conversion 134R présente avantageusement une épaisseur minimale de $\lambda_2/2n_2$, avec $\lambda_2$ la longueur d'onde du deuxième rayonnement et $n_2$ l'indice optique de la deuxième couche de conversion 134R, pour une meilleure efficacité de conversion.

Selon un mode de réalisation non illustré, il est possible de prévoir également un confinement vertical de l'empilement actif 105 de la troisième LED, au moyen de premier et second filtres réfléchissants multicouches formant une cavité Fabry-Perot résonante présentant un pic de transmittance à la longueur d'onde du rayonnement émis par l'empilement actif 105. Cela permet d'améliorer la saturation du rayonnement finalement extrait de ladite cavité Fabry-Perot. En effet, d'une manière générale, le confinement vertical dans une cavité de Fabry-Perot permet une redistribution spectrale et un affinement spectral de l'émission spontanée, donc une amélioration de la saturation et de la résolution. La largeur à mi-hauteur du rayonnement finalement extrait est typiquement de l'ordre de 10 à 20 nm, contre typiquement 100 nm pour le rayonnement initial. C'est l'ingénierie de conception de la réflectivité de chaque filtre réfléchissant multicouche qui définit précisément la redistribution spectrale et la largeur à mi-hauteur du rayonnement extrait, et cette ingénierie est réalisée pour chacun des premier et deuxième dispositifs optoélectroniques, et le cas échéant pour la troisième LED.

Chacune des cavités Fabry-Perot permet, par le réglage de son accord et de son facteur de qualité, d'affiner le pic de transmittance pour atteindre une couleur saturée. D'une manière connue de l'état de la technique, le réglage d'une cavité est défini par le déphasage $d\Phi$ entre deux rayons sortants successifs :

$$d\Phi(\theta) = 2knl(\cos\theta)$$

où n est l'indice de réfraction de la cavité ; l est l'épaisseur de la cavité ; $\theta$ est l'angle de réfraction des rayons et $k = 2\pi/\lambda$ avec $\lambda$ la longueur d'onde des rayons. Les rayons successifs interfèrent constructivement si leur déphasage $d\Phi$ est égal à $2\pi$ ; et ils interfèrent destructivement si leur déphasage $d\Phi$ est égal à $\pi$.

Chacune des cavités Fabry-Pérot peut être configurée plus particulièrement pour être résonante et pour avoir

un pic de transmittance pour le rayonnement converti par les fluorophores, pour une direction moyenne de propagation qui perpendiculaire au plan du dispositif optoélectronique (plan des différentes couches mentionnées précédemment), c'est-à-dire pour un angle θ=0.

Dans ce cas, la distance entre le premier 131R, 131G et le deuxième filtre réfléchissant 132R, 132G qui constituent les miroirs de la cavité Fabry-Pérot (c'est-à-dire l'épaisseur des couches situées entre ces deux filtres) est choisie de sorte que le déphasage subi par le rayonnement converti, pour un aller-retour dans la cavité (trajet aller-retour avec une direction de propagation perpendiculaire aux miroirs), soit égal à m×2π radians, où m est un nombre entier.

Quoiqu'il en soit, on notera que, pour que la cavité Fabry-Pérot soit résonnante pour le rayonnement converti, la distance entre les premier 131R, 131G et deuxième 132R, 132G filtres réfléchissants doit avoir une valeur spécifique, bien appropriée (en d'autres termes, la cavité doit être « accordée » avec la longueur d'onde moyenne de ce rayonnement).

En pratique, la ou les valeurs particulières de distance entre les premier et deuxièmes filtres réfléchissants, qui permettent de satisfaire cette condition de résonance, peuvent être déterminées lors d'une phase de dimensionnement du dispositif (par exemple par simulation numérique), en tenant compte :

- du déphasage à la réflexion sur chacun des premier et deuxième filtres réfléchissants, à la longueur d'onde moyenne du rayonnement converti, et
- de l'indice de réfraction de la couche, ou des couches qui s'étendent entre ces deux filtres.

Chacun des premier et deuxième filtres réfléchissants multicouches est par exemple un miroir de Bragg, réalisé par exemple par une combinaison de couches minces diélectriques d'épaisseur $\lambda/4n$ et de haut et bas indices, par exemple de $SiO_2/TiO_2$ ou $SiO_2/Si_3N_4$. Les indices optiques de ces matériaux sont, à 460 nm, respectivement de 1,464/2,7878 et 1,464/2,0751. Alternativement, chacun des premier et deuxième filtres réfléchissants multicouches est par exemple un empilement non-périodique de couches d'épaisseurs optimisées, permettant d'obtenir un gabarit de filtre précis.

Chacun des premiers filtres réfléchissants multicouches 131G du premier dispositif optoélectronique 110G, et 131R du deuxième dispositif optoélectronique 110R, présente de préférence, respectivement pour le rayonnement converti par les premiers et deuxièmes fluorophores, une réflectivité supérieure ou égale à 90% ; plus préférentiellement supérieure ou égale à 95% ; encore plus préférentiellement supérieure ou égale à 99%. D'une manière générale dans le cas d'un miroir de Bragg réalisé par une combinaison de couches minces diélectriques d'épaisseur $\lambda/4n$ et de haut et bas indices, le nombre de couples de couches minces diélectriques faible indice/fort indice permettant d'obtenir une réflectivité suffisante à la longueur d'onde du rayonnement converti est fonction du contraste d'indice entre les deux couches minces du couple. L'épaisseur d'une couche mince diélectrique est typiquement de l'ordre de quelques dizaines de nm ; l'épaisseur d'un couple faible indice/fort indice est typiquement compris entre 100 nm et 200 nm ; et l'épaisseur d'un miroir de Bragg comportant un empilement de plusieurs couples de couches minces diélectriques faible indice/fort indice est typiquement de l'ordre du $\mu m$ et de préférence inférieure ou égale à 1 $\mu m$.

Chacun des premiers filtres réfléchissants multicouches 131G du premier dispositif optoélectronique 110G, et 131R du deuxième dispositif optoélectronique 110R, présente par ailleurs avantageusement, pour le rayonnement non converti par les premiers et deuxièmes fluorophores - c'est-à-dire pour le rayonnement émis par la couche active 105 à la longueur d'onde de pompe, une grande transmittivité afin de disposer d'un maximum de photons de pompe, émis par la couche active 105, dans la cavité. En particulier, ladite grande transmittivité est préférentiellement supérieure ou égale à 90% ; plus préférentiellement supérieure ou égale à 95% ; encore plus préférentiellement supérieure ou égale à 99%.

Le second filtre réfléchissant multicouche 132G du premier dispositif optoélectronique 110G présente, pour le rayonnement converti par les premiers fluorophores de la première couche de conversion 134G, une réflectivité strictement inférieure à celle du premier filtre réfléchissant multicouche 131G du premier dispositif optoélectronique 110G, pour le rayonnement converti par les premiers fluorophores de la première couche de conversion 134G. De même, le second filtre réfléchissant multicouche 132R du deuxième dispositif optoélectronique 110R présente, pour le rayonnement converti par les deuxièmes fluorophores de la deuxième couche de conversion 134R, une réflectivité strictement inférieure à celle du premier filtre réfléchissant multicouche 131R du deuxième dispositif optoélectronique 110R, pour le rayonnement converti par les deuxièmes fluorophores de la deuxième couche de conversion 134G. On dit que les seconds filtres réfléchissants multicouches, ou filtres d'extraction, 132G du premier dispositif optoélectronique 110G et 132R du deuxième dispositif optoélectronique 110R, présentent une réflectivité « dégradée » : c'est ce qui leur permet d'extraire respectivement une partie des premier et deuxième rayonnements. La réflectivité du second filtre réfléchissant multicouche 132G du premier dispositif optoélectronique 110G pour le rayonnement converti par les premiers fluorophores est préférentiellement comprise dans l'intervalle [30% ; 70%] ; plus préférentiellement dans l'intervalle [40% ; 70%] ou [30% ; 60%] ; encore plus préférentiellement dans l'intervalle [40% ; 60%]. De même, la réflectivité du second filtre réfléchissant multicouche 132R du deuxième dispositif optoélectronique 110R pour le rayonnement converti par les deuxièmes fluorophores est préférentiellement comprise dans l'intervalle [30% ; 70%] ; plus préférentiellement dans l'intervalle [40% ; 70%] ou [30% ; 60%] ; encore plus préférentiellement dans l'intervalle [40% ; 60%].

Chacun des seconds filtres réfléchissants multicouches 132G du premier dispositif optoélectronique 110G, et 132R du deuxième dispositif optoélectronique 110R, présente par ailleurs avantageusement, pour le rayonnement non converti par les premiers et deuxièmes fluorophores - c'est-à-dire pour le rayonnement émis par la couche active 105 à la longueur d'onde de pompe, une grande réflectivité afin de « recycler » les photons de pompes non encore convertis par les premiers ou deuxième fluorophores, et augmenter ainsi le taux de conversion des première et deuxième couches de conversion 134G, 134R. En particulier, ladite grande réflectivité est préférentiellement supérieure ou égale à 90% ; plus préférentiellement supérieure ou égale à 95% ; encore plus préférentiellement supérieure ou égale à 99%.

Par ailleurs, les première et deuxième couches de conversion 134R, 134G sont confinées latéralement par un miroir 133 réfléchissant à la fois les premier et deuxième rayonnements afin de limiter le crosstalk, et le rayonnement non converti par les premier et deuxième fluorophores afin d'améliorer son taux de conversion. Le miroir 133 est typiquement en métal, par exemple en or Au, argent Ag, titane Ti, cuivre Cu, aluminium Al, tungstène W ou tout autre métal apte à réfléchir la lumière visible. Pour des raisons technologiques d'alignement et pour éviter tout couplage plasmonique, le miroir 133 est préférentiellement séparé latéralement des première et deuxième couches de conversion 134R, 134G par un intervalle d'un matériau de bas indice, par exemple un oxyde comme du $SiO_2$ ou un nitrure comme du Si3N$_4$, typiquement de quelques dizaines de nm d'épaisseur, par exemple 75 nm.

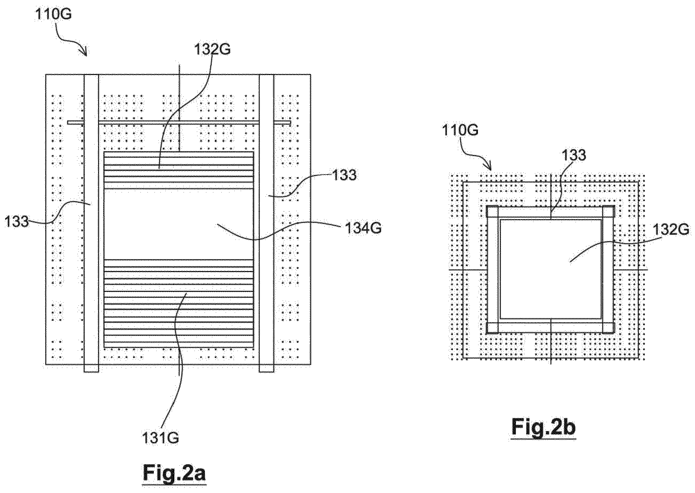

La figure 2a montre schématiquement une vue en coupe d'un dispositif optoélectronique, par exemple le premier dispositif optoélectronique 110G, selon un premier mode de réalisation de l'invention. La figure 2b montre schématiquement une vue de dessus du premier dispositif optoélectronique 110G de la figure 2a.

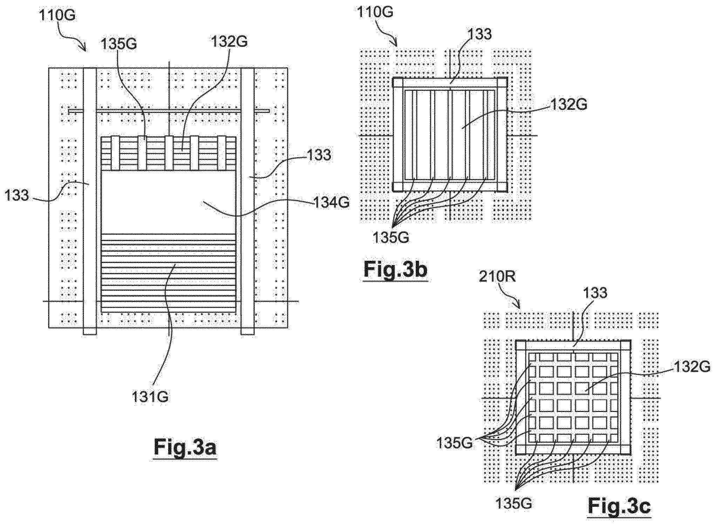

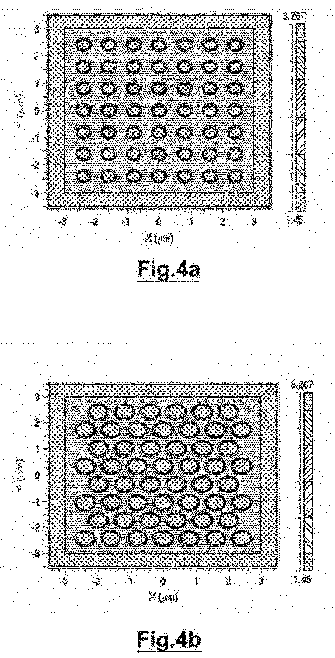

La figure 3a montre schématiquement une vue en coupe d'un dispositif optoélectronique, par exemple le premier dispositif optoélectronique 110G, selon un deuxième mode de réalisation de l'invention où le filtre d'extraction comporte en outre un réseau d'extraction du rayonnement converti par les fluorophores, en l'occurrence un réseau d'extraction 135G du premier rayonnement émis par les premiers fluorophores. La figure 3b montre schématiquement une vue de dessus d'un dispositif optoélectronique, par exemple le premier dispositif optoélectronique 110G, selon une première variante du deuxième mode de réalisation, où le réseau d'extraction comporte des cristaux photoniques 2D avec une texturation selon une dimension planaire. La figure 3c montre schématiquement une vue de dessus d'un dispositif optoélectronique, par exemple le premier dispositif optoélectronique 110G, selon une deuxième variante du deuxième mode de réalisation, où le réseau d'extraction comporte des cristaux photoniques 2D avec une texturation selon deux dimensions planaires. Une règle de conception générale est que la période du réseau d'extraction est comprise entre $\lambda/2$ et $\lambda$, avec $\lambda$ la longueur d'onde à extraire. L'ingénierie complète de dimensionnement du réseau d'extraction dépend notamment de l'épaisseur et du contraste d'indice du réseau d'extraction, de la longueur d'onde à extraire et de la directivité souhaitée. La figure 4a montre schématiquement une vue de dessus d'un dispositif optoélectronique selon un premier exemple de la deuxième variante de la figure 3c. Selon ce premier exemple, les cristaux photoniques présentent une maille carrée. La figure 4b montre schématiquement une vue de dessus d'un dispositif optoélectronique selon un deuxième exemple de la deuxième variante de la figure 3c. Selon ce deuxième exemple, les cristaux photoniques présentent une maille triangulaire. Pour chacun des premier et deuxième exemples, la texturation peut être obtenue au moyen de trous ou au contraire au moyen de piliers.

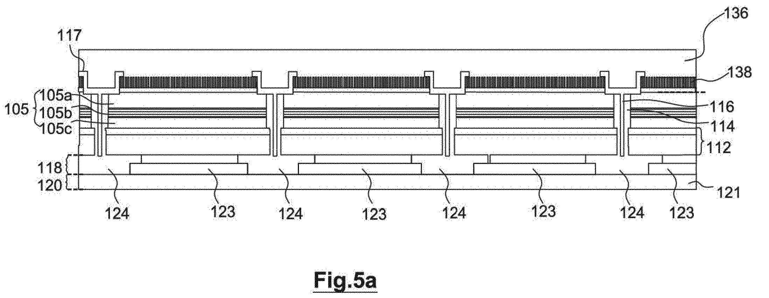

Un procédé de fabrication d'un pixel, comportant les premier et deuxième dispositifs optoélectroniques et la troisième LED précédemment décrits, est à présent décrit en lien avec les figures 5a à 5f. Toutefois, chacun des premier et deuxième dispositifs optoélectroniques peut être fabriqué individuellement.

Le procédé comporte tout d'abord une étape de réalisation d'une architecture de LED telle que précédemment décrite, comportant par exemple un empilement actif 105, agencé sur un empilement d'interconnexion 118, lui-même agencé sur un circuit intégré de contrôle 120. Le procédé comporte ensuite une étape facultative de réalisation d'une couche 138 texturée telle que précédemment décrite. Le procédé comporte ensuite une étape de dépôt, typiquement par dépôt conforme, d'une première couche 136 d'isolant tel que du $SiO_2$, soit sur la couche 138 texturée, soit directement sur l'empilement actif 105. Le procédé comporte ensuite une étape de planarisation, typiquement par polissage mécano-chimique CMP (de l'anglais « chemical-mechanical polishing »), de la première couche 136. La figure 5a montre le résultat obtenu à l'issue de la planarisation de la première couche 136.

Le procédé comporte ensuite une étape de dépôt d'une multicouche, destinée à former le premier filtre réfléchissant multicouche 131G du premier dispositif optoélectronique 110G, sur la première couche 136 ; puis une étape de gravure de ladite multicouche de manière à définir le premier filtre réfléchissant multicouche 131G. Ladite étape de gravure comporte typiquement le dépôt d'un masque suivi d'une lithogravure DUV (de l'anglais « deep UV »). Alternativement, ladite étape de gravure peut être une gravure ionique réactive RIE (de l'anglais « Reactive-Ion Etching »). Le procédé comporte ensuite une étape de dépôt d'une deuxième couche 136 d'isolant, suivie d'une étape de planarisation de la deuxième couche 136, analogues au dépôt et à la planarisation de la première couche 136, décrits au paragraphe précédent.

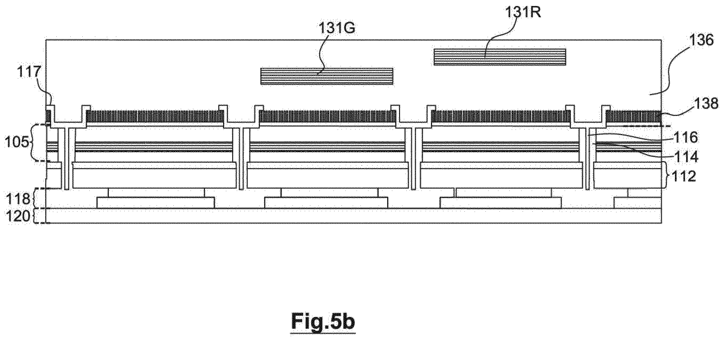

Le procédé comporte ensuite une étape de dépôt d'une multicouche, destinée à former le premier filtre réfléchissant multicouche 131R du deuxième dispositif optoélectronique 110R, sur la deuxième couche 136 ; puis une étape de gravure de ladite multicouche de manière à définir le premier filtre réfléchissant multicouche 131R, analogue à celle décrite au paragraphe précédent. Le procédé comporte ensuite une étape de dépôt d'une troisième couche 136 d'isolant, suivie d'une étape de planarisation de la troisième couche, analogues au dépôt et à la planarisation de la première couche 136, décrits précédemment. La figure 5b montre le résultat obtenu à l'issue de la planarisation de la troisième couche 136.

Le procédé comporte ensuite une étape de dépôt d'un premier matériau de conversion, destiné à former la première couche de conversion 134G, sur la troisième couche 136. Ce dépôt est par exemple réalisé par dépôt à la tournette, ou « spin coating » en anglais. Le procédé comporte ensuite une étape de gravure dudit premier matériau de manière à définir la première couche de conversion 134G. Cette étape de gravure est par exemple réalisée par gravure ionique IBE (de l'anglais « ion-beam etching »), en particulier par gravure ionique réactive RIE. Le procédé comporte ensuite une étape de dépôt d'une quatrième couche 136 d'isolant, suivie d'une étape de planarisation de la quatrième couche, analogues au dépôt et à la planarisation de la première couche 136, décrits précédemment.

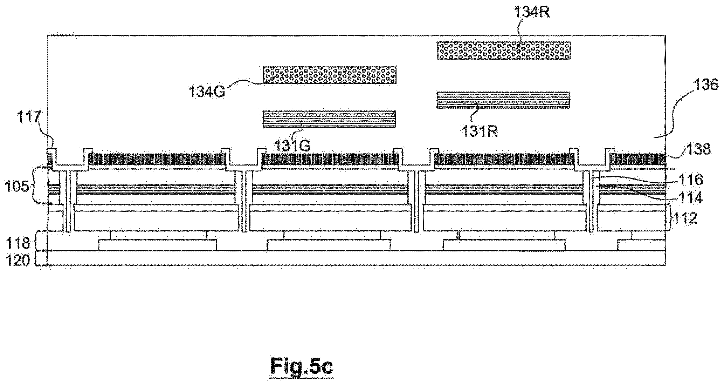

Le procédé comporte ensuite une étape de dépôt d'un deuxième matériau de conversion, destiné à former la deuxième couche de conversion 134R, sur la quatrième couche 136. Ce dépôt est par exemple réalisé par dépôt à la tournette, ou « spin coating » en anglais. Le procédé comporte ensuite une étape de gravure dudit deuxième matériau de manière à définir la première couche de conversion 134R. Cette étape de gravure est par exemple réalisée par gravure ionique IBE (de l'anglais « ion-beam etching »), en particulier par gravure ionique réactive RIE. Le procédé comporte ensuite une étape de dépôt d'une cinquième couche 136 d'isolant, suivie d'une étape de planarisation de la cinquième couche, analogues au dépôt et à la planarisation de la première couche 136, décrits précédemment. La figure 5c montre le résultat obtenu à l'issue de la planarisation de la cinquième couche 136.

Le procédé comporte ensuite une étape de dépôt d'une multicouche, destinée à former le second filtre réfléchissant multicouche 132G du premier dispositif optoélectronique 110G, sur la cinquième couche 136 ; puis une étape de gravure de ladite multicouche de manière à définir le second filtre réfléchissant multicouche 131G. Ladite étape de gravure comporte typiquement le dépôt d'un masque suivi d'une lithogravure DUV (de l'anglais « deep UV »). Alternativement, ladite étape de gravure peut être une gravure ionique réactive RIE (de l'anglais « Reactive-Ion Etching »). Le procédé comporte ensuite une étape de dépôt d'une sixième couche 136 d'isolant, suivie d'une étape de planarisation de la sixième couche 136, analogues au dépôt et à la planarisation de la première couche 136, décrits précédemment.

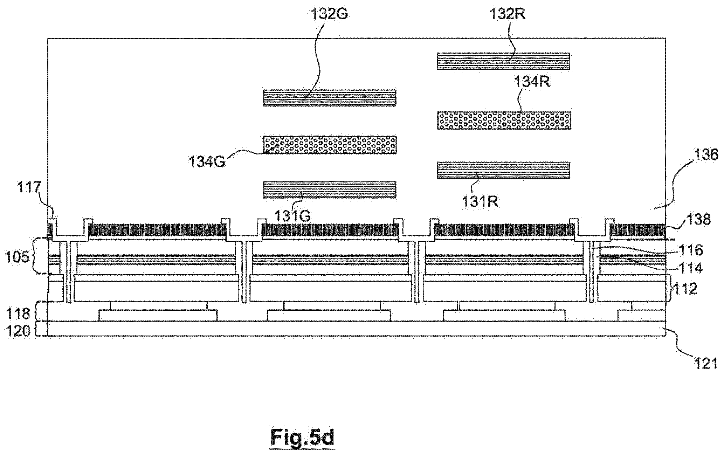

Le procédé comporte ensuite une étape de dépôt d'une multicouche, destinée à former le second filtre réfléchissant multicouche 132R du deuxième dispositif optoélectronique 110R, sur la sixième couche 136 ; puis une étape de gravure de ladite multicouche de manière à définir le second filtre réfléchissant multicouche 132R, analogue à celle décrite au paragraphe précédent. Le procédé comporte ensuite une étape de dépôt d'une septième couche 136 d'isolant, suivie d'une étape de planarisation de la septième couche, analogues au dépôt et à la planarisation de la première couche 136, décrits précédemment. La figure 5d montre le résultat obtenu à l'issue de la planarisation de la septième couche 136.

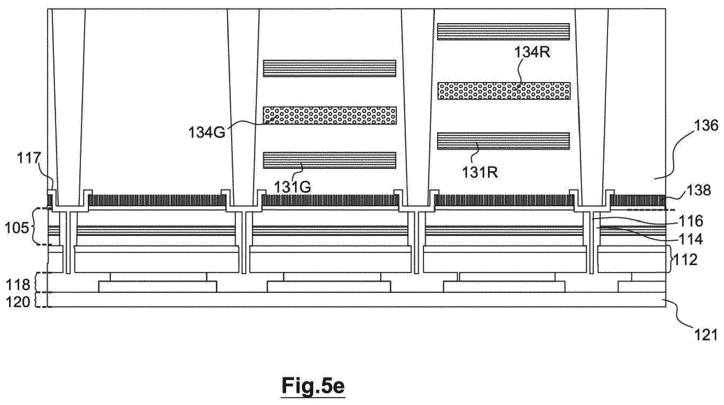

Le procédé comporte ensuite une étape d'ouverture de tranchées délimitant la troisième LED et chacun des premier et deuxième dispositifs optoélectroniques, par exemple par gravure ionique réactive RIE profonde, chaque tranchée étant alignée avec un élément 117 de reprise de contact. La figure 5e montre le résultat obtenu à l'issue de l'étape d'ouverture des tranchées.

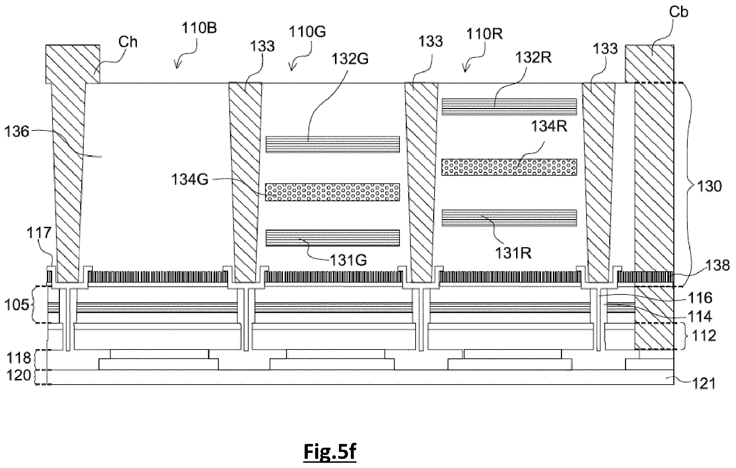

Le procédé comporte ensuite une étape de dépôt d'un métal dans les tranchées, par exemple par dépôt électrochimique ECD (de l'anglais « electrochemical déposition »), suivie d'une étape de planarisation, par exemple par CMP, afin d'éviter tout court-circuit. Le procédé comporte ensuite une étape de réalisation de contacts Ch et Cb, aux extrémités des lignes de cathode et d'anode, typiquement au moyen du dépôt d'un métal suivi d'une gravure. La figure 5f montre le résultat obtenu à l'issue de l'étape de réalisation des contacts Ch et Cb.

Naturellement, l'invention n'est pas limitée aux modes de réalisation décrits en référence aux figures et des variantes pourraient être envisagées sans sortir du cadre de l'invention, qui est défini par les revendications.

## Revendications

1. Dispositif optoélectronique (110G, 110R) comportant :

   - une LED adaptée à l'émission d'un rayonnement, la LED comportant une couche active (105), et
   - une couche de conversion (134G, 134R) s'étendant au-dessus de la couche active (105) de la LED et comportant une pluralité de fluorophores adaptés à la conversion du rayonnement émis par la LED, la couche de conversion (134G, 134R) étant confinée latéralement par un miroir (133) réfléchissant à la fois le rayonnement converti par les fluorophores et le rayonnement non converti par les fluorophores, et le dispositif étant **caractérisé**

**en ce que** la couche de conversion (134G, 134R) est confinée verticalement entre des premier (131G, 131R) et second (132G, 132R) filtres réfléchissants multicouches formant une cavité Fabry-Perot résonante, qui bloque le rayonnement non converti par les fluorophores et qui a un pic de transmittance pour le rayonnement converti par les fluorophores.

2. Dispositif optoélectronique (110G, 110R) selon la revendication précédente, **caractérisé en ce que** les fluorophores sont des nanophosphores.

3. Dispositif optoélectronique (110G, 110R) selon la revendication précédente, **caractérisé en ce que** les nanophosphores sont choisis parmi $SrSi_2O_2N_2{:}Eu^{2+}$ ; $\beta$-SIALON ; $Y_3Al_5O_{12}{:}Ce^{3+}$ ; LuAG:Ce ; $LuYAlMgSiO_3{:}Ce$ ; $SrSi_5N_8{:}Eu^{2+}$ ; $(BaSr)_2Si_5N_8{:}Eu^{2+}$ ; $(Ca, Sr)AlSiN_3{:}Eu^{2+}$ ; $Sr[LiAl_3N_4]{:}Eu^{2+}$ ; $Sr[Mg_3SiN_4]{:}Eu^{2+}$; $Sr_1{-}xCa_xS{:}Eu^{2+}$.

4. Dispositif optoélectronique (110G, 110R) selon la revendication 1, **caractérisé en ce que** les fluorophores sont des boîtes quantiques 3D.

5. Dispositif optoélectronique (110G, 110R) selon la revendication précédente, **caractérisé en ce que** les boîtes quantiques 3D sont choisies parmi : ZnS ; ZnSe ; CdS ; CdSe ; CdZnSe ; CdTe ; PbS ; InP ; $CuInS_2$; $CuGaS_2$ ; $CuInSe_2$ ; $CuGaSe_2$ ; $CuInGaSe_2$ ; CuSe ; InSe ; GaSe ou toute combinaison des alliages précédents.

6. Dispositif optoélectronique (110G, 110R) selon l'une quelconque des revendications précédentes, **caractérisé en ce que** le rayonnement converti par les fluorophores est extrait de la cavité Fabry-Perot résonante par l'un des premier (131G, 131R) ou second (132G, 132R) filtres réfléchissants multicouches, dit « filtre d'extraction », et **en ce que** ledit filtre d'extraction comporte un réseau d'extraction (135G, 135R) du rayonnement converti par les fluorophores.

7. Dispositif optoélectronique (110G, 110R) selon l'une quelconque des revendications précédentes, **caractérisé en ce que** le premier filtre réfléchissant multicouche (131G, 131R) s'étend entre la couche active (105) et la couche de conversion (134G, 134R) tandis que le second filtre réfléchissant multicouche (132G, 132R) s'étend au-dessus de la couche de conversion (134G, 134R), et **en ce que** le second filtre réfléchissant multicouche (132G, 132R) a une réflectivité supérieure à 30% pour le rayonnement converti par les fluorophores.

8. Pixel comportant des premier (110G) et deuxième (110R) dispositifs optoélectroniques selon l'une quelconque des revendications précédentes, le premier dispositif optoélectronique (110G) comportant une première LED et le deuxième dispositif optoélectronique (110R) comportant une deuxième LED, le rayonnement converti par les fluorophores de la deuxième LED étant distinct du rayonnement converti par les fluorophores de la première LED.

9. Pixel selon la revendication précédente, **caractérisé en ce qu'**il comporte en outre une troisième LED (110B) pour l'émission d'un rayonnement distinct des rayonnements convertis par les fluorophores des premier et deuxième dispositifs optoélectroniques (110G, 110R).

10. Pixel selon la revendication précédente, **caractérisé en ce que** la troisième LED (110B) présente une couche active (105) confinée latéralement par un miroir et verticalement entre des premier et second filtres réfléchissants multicouches formant une cavité Fabry-Perot résonante ayant un pic de transmittance pour le rayonnement émis par la couche active.

11. Pixel selon la revendication précédente, **caractérisé en ce que** le rayonnement émis par la couche active est extrait de la cavité Fabry-Perot résonante par l'un des premier ou filtres réfléchissants multicouches, dit « filtre d'extraction », et **en ce que** ledit filtre d'extraction comporte un réseau d'extraction du rayonnement émis par la couche active.

12. Procédé de fabrication d'un dispositif optoélectronique (110G, 110R) selon l'une quelconque des revendications 1 à 7, comportant les étapes suivantes :

- réaliser une LED comportant une couche active (105) ;
- réaliser un premier filtre réfléchissant multicouche (131G, 131R) au-dessus de la couche active (105) ;
- réaliser une couche de conversion (134G, 134R) comportant une pluralité de fluorophores, configurée pour convertir par fluorescence un rayonnement émis par la couche active (105) ;
- réaliser un second filtre réfléchissant multicouche (132G, 132R), de manière que la couche de conversion (134G, 134R) soit confinée verticalement entre les premier (131G, 131R) et second (132G, 132R) filtres réfléchissants multicouches, les premier et second filtres réfléchissants multicouches formant une cavité Fabry-Perot résonante, bloquant un rayonnement non converti par les fluorophores et ayant un pic de transmittance pour le rayonnement converti par les fluorophores ;
- réaliser autour de la couche de conversion (134G, 134R) un miroir (133) réfléchissant à la fois le rayonnement converti par les fluorophores et le rayonnement non converti par les fluorophores, de manière à confiner latéralement la couche de conversion (134G, 134R).

13. Procédé de fabrication d'un pixel selon l'une quelconque des revendications 8 à 11, comportant les étapes suivantes :

- réaliser des première et deuxième LED comportant chacune une couche active (105) ;
- réaliser un premier filtre réfléchissant multicouche (131G), adapté à un premier rayonnement, au-dessus de la couche active (105) de la première LED ;
- réaliser un premier filtre réfléchissant multicouche (131R), adapté à un deuxième rayonnement distinct du premier rayonnement, au-dessus de la couche active (105) de la deuxième LED ;
- réaliser une première couche de conversion (134G) comportant une pluralité de premiers fluorophores, configurée pour convertir par fluorescence un rayonnement émis par la couche active (105) de la première LED de manière à obtenir le premier rayonnement ;
- réaliser une deuxième couche de conversion (134R) comportant une pluralité de deuxièmes fluorophores, configurée pour convertir par fluorescence un rayonnement émis par la couche active (105) de la deuxième LED de manière à obtenir le deuxième rayonnement ;
- réaliser un second filtre réfléchissant multicouche (132G), adapté au premier rayonnement, de manière que la première couche de conversion (134G) soit confinée verticalement entre les premier et second filtres réfléchissants multicouches (131G, 132G) adaptés au premier rayonnement et formant une cavité Fabry-Perot résonante, bloquant un rayonnement non converti par les premiers fluorophores et ayant un pic de transmittance pour le premier rayonnement ;
- réaliser un second filtre réfléchissant multicouche (132R), adapté au deuxième rayonnement, de manière que la deuxième couche de conversion (134R) soit confinée verticalement entre les premier et second filtres réfléchissants multicouches (131R, 132R) adaptés au deuxième rayonnement et formant une cavité Fabry-Perot résonante, bloquant un rayonnement non converti par les deuxième fluorophores et ayant un pic de transmittance pour le deuxième rayonnement ;
- réaliser autour des première et deuxième couches de conversion (134G, 134R) un miroir (133) réfléchissant à la fois les premier et deuxième rayonnements et le rayonnement non converti par les premiers et deuxièmes fluorophores, de manière à confiner latéralement les première et deuxième couches de conversion (134G, 134R).

## Patentansprüche

1. Optoelektronische Vorrichtung (110G, 110R), umfassend:

- eine für die Ausgabe einer Strahlung geeignete LED, wobei die LED eine aktive Schicht (105) umfasst, und,
- eine Umwandlungsschicht (134G, 134R), die sich oberhalb der aktiven Schicht (105) der LED erstreckt und eine Vielzahl von Leuchtstoffen umfasst, die zum Umwandeln der von der LED ausgegebenen Strahlung geeignet sind, wobei die Umwandlungsschicht (134G, 134R) seitlich durch einen Spiegel (133) eingeschlossen ist, der sowohl die von den Leuchtstoffen umgewandelte Strahlung als die die nicht von den Leuchtstoffen umgewandelte Strahlung reflektiert, und wobei die Vorrichtung **dadurch gekennzeichnet ist, dass** die Umwandlungsschicht (134G, 134R) vertikal zwischen einem ersten (131G, 131R) und einem zweiten (132G, 132R) mehrschichtigen, reflektierenden Filter eingeschlossen sind die eine Fabry-Perot-Resonatorausnehmung bilden, die die nicht von den Leuchtstoffen umgewandelte Strahlung blockiert und die eine Durchlässigkeitsspitze für die von den Leuchtstoffen umgewandelte Strahlung aufweist.

2. Optoelektronische Vorrichtung (110G, 110R) gemäß dem voranstehenden Anspruch, **dadurch gekennzeichnet, dass** die Leuchtstoffe Nanophosphore sind.

3. Optoelektronische Vorrichtung (110G, 110R) gemäß dem voranstehenden Anspruch, **dadurch gekennzeichnet, dass** die Nanophosphore aus $SrSi_2O_2N_2$:$EU^{2+}$; β-SIALON; $Y_3Al_5O_{12}$:$Ce^{3+}$; LuAG:Ce; $LuYAlMgSiO_3$:Ce; $SrSi_5N_8$:$Eu^{2+}$; $(BaSr)_2Si_5N_8$:$Eu^{2+}$; (Ca, Sr)$AlSiN_3$:$Eu^{2+}$; $Sr[LiAl_3N_4]$:$Eu^{2+}$ ; $Sr[Mg_3SiN_4]$:$Eu^{+2}$; $Sr_{1-x}Ca_xS$:$Eu^{2+}$ ausgewählt sind.

**4.** Optoelektronische Vorrichtung (110G, 110R) gemäß Anspruch 1, **dadurch gekennzeichnet, dass** die Leuchtstoffe 3D-Quantenpunkte sind.

**5.** Optoelektronische Vorrichtung (110G, 110R) gemäß dem voranstehenden Anspruch, **dadurch gekennzeichnet, dass** die 3D-Quantenpunkte ausgewählt sind aus: ZnS; ZnSe; CdS; CdSe; CdZnSe; CdTe; PbS; InP; CuInS$_2$; CuGaS$_2$; CuInSe$_2$; CuGaSe$_2$; CuInGaSe$_2$; CuSe; InSe; GaSe oder jeder Kombination der vorgenannten Legierungen.

**6.** Optoelektronische Vorrichtung (110G, 110R) gemäß irgendeinem der voranstehenden Ansprüche, **dadurch gekennzeichnet, dass** die von den Leuchtstoffen umgewandelte Strahlung aus der Fabry-Perot-Resonatorausnehmung durch einen des ersten (131G, 131R) oder des zweiten (132G, 132R) mehrschichtigen, reflektierenden Filter, bezeichnet als "Extraktionsfilter", extrahiert ist, und dass der genannte Extraktionsfilter ein Extraktionsnetz (135G, 135R) der von den Leuchtstoffen umgewandelten Strahlung umfasst.

**7.** Optoelektronische Vorrichtung (110G, 110R) gemäß irgendeinem der voranstehenden Ansprüche, **dadurch gekennzeichnet, dass** der erste mehrschichtige, reflektierende Filter (131G, 131R) sich zwischen der aktiven Schicht (105) und der Umwandlungsschicht (134G, 134R) erstreckt, während der zweite mehrschichtige, reflektierende Filter (132G, 132R) sich oberhalb der Umwandlungsschicht (134G, 134R) erstreckt und dass der zweite mehrschichtige, reflektierende Filter (132G, 132R) für die von den Leuchtstoffen umgewandelte Strahlung eine Reflektivität von mehr als 30 % aufweist.

**8.** Pixel, umfassend erste (110G) und zweite (110R) optoelektronische Vorrichtungen gemäß irgendeinem der voranstehenden Ansprüche, wobei die erste optoelektronische Vorrichtung (110G) eine erste LED umfasst und die zweite optoelektronische Vorrichtung (110R) eine zweite LED umfasst, wobei die von den Leuchtstoffen der zweite LED umgewandelte Strahlung von der von den Leuchtstoffen der ersten LED umgewandelten Strahlung unterschiedlich ist.

**9.** Pixel gemäß dem voranstehenden Anspruch, **dadurch gekennzeichnet, dass** es darüber hinaus eine dritte LED (110B) für die Ausgabe einer Strahlung umfasst, die von den Leuchtstoffen der ersten und der zweiten optoelektronischen Vorrichtung (110G, 110R) umgewandelten Strahlungen unterschiedlich ist.

**10.** Pixel gemäß dem voranstehenden Anspruch, **dadurch gekennzeichnet, dass** die dritte LED (110B) eine aktive Schicht (105) aufweist, die seitlich durch einen Spiegel und vertikal zwischen dem ersten und dem zweiten mehrschichtigen reflektierenden Spiegel eingeschlossen ist, der eine Fabry-Perot-Resonatorausnehmung bildet, die eine Durchlässigkeitsspitze für die von der aktiven Schicht ausgegebene Strahlung aufweist.

**11.** Pixel gemäß dem voranstehenden Anspruch, **dadurch gekennzeichnet, dass** die von der aktiven Schicht ausgegebene Strahlung aus der Fabry-Perot-Resonatorausnehmung durch einen des ersten oder des mehrschichtigen, reflektierenden Filter, bezeichnet als "Extraktionsfilter", extrahiert ist, und dass der genannte Extraktionsfilter ein Extraktionsnetz der von der aktiven Schicht ausgegebenen Strahlung umfasst.

**12.** Herstellungsverfahren einer optoelektronischen Vorrichtung (110G, 110R) gemäß irgendeinem der Ansprüche 1 bis 7, umfassend die folgenden Schritte:

- Realisieren einer LED, die eine aktive Schicht (105) umfasst;
- Realisieren eines ersten mehrschichtigen, reflektierenden Filters (131G, 131R) oberhalb der aktiven Schicht (105);
- Realisieren einer Umwandlungsschicht (134G, 134R), die eine Vielzahl von Leuchtstoffen umfasst, die zum Umwandeln einer von der aktiven Schicht (105) ausgegebenen Strahlung per Fluoreszenz ausgestaltet ist;
- Realisieren eines zweiten mehrschichtigen, reflektierenden Filters (132G, 132R) derart, dass die Umwandlungsschicht (134G, 134R) vertikal zwischen dem ersten (131G, 131R) und dem zweiten (132G, 132R) mehrschichtigen, reflektierenden Filter eingeschlossen ist, wobei der erste und der zweite mehrschichtige, reflektierende Filter eine Fabry-Perot-Resonatorausnehmung bilden, eine nicht von den Leuchtstoffen umgewandelte Strahlung blockieren und eine Durchlässigkeitsspitze für die von den Leuchtstoffen umgewandelte Strahlung aufweisen;
- Realisieren eines Spiegels (133) um die Umwandlungsschicht (134G, 134R) herum, der sowohl die von den Leuchtstoffen umgewandelte Strahlung als auch die nicht von den Leuchtstoffen umgewandelte Strahlung derart reflektiert, dass die Umwandlungsschicht (134G, 134R) seitlich eingeschlossen wird.

13. Herstellungsverfahren eines Pixels gemäß irgendeinem der Ansprüche 8 bis 11, umfassend die folgenden Schritte:

- Realisieren der ersten und der zweiten LED, die jeweils eine aktive Schicht (105) umfassen;
- Realisieren eines ersten mehrschichtigen, reflektierenden Filters (131G), der für eine erste Strahlung geeignet ist, oberhalb der aktiven Schicht (105) der ersten LED;
- Realisieren eines ersten mehrschichtigen, reflektierenden Filters (131R), der für eine von der ersten Strahlung unterschiedliche zweite Strahlung geeignet ist, oberhalb der aktiven Schicht (105) der zweiten LED;
- Realisieren einer ersten, eine Vielzahl von ersten Leuchtstoffen umfassenden Umwandlungsschicht (134G), die zum Umwandeln per Fluoreszenz einer Strahlung ausgestaltet ist, die von der ersten aktiven Schicht (105) der ersten LED derart ausgegeben wird, dass die erste Strahlung erhalten wird;
- Realisieren einer zweiten, eine Vielzahl von zweiten Leuchtstoffen umfassenden Umwandlungsschicht (134R), die zum Umwandeln per Fluoreszenz einer Strahlung ausgestaltet ist, die von der aktiven Schicht (105) der zweiten LED derart ausgegeben wird, dass die zweite Strahlung erhalten wird;
- Realisieren eines zweiten mehrschichtigen, reflektierenden Filters (132G), der derart für die erste Strahlung geeignet ist, dass die erste Umwandlungsschicht (134G) vertikal zwischen dem ersten und dem zweiten mehrschichtigen, reflektierenden Filter (131G, 132G) eingeschlossen ist, die für die erste Strahlung geeignet sind und eine Fabry-Perot-Resonatorausnehmung bilden, eine nicht von den ersten Leuchtstoffen umgewandelte Strahlung blockieren und eine Durchlässigkeitsspitze für die erste Strahlung aufweisen;
- Realisieren eines zweiten mehrschichtigen, reflektierenden Filters (132R), der derart für die zweite Strahlung geeignet ist, dass die zweite Umwandlungsschicht (134R) vertikal zwischen dem ersten und dem zweiten mehrschichtigen, reflektierenden Filter (131R, 132R) eingeschlossen ist, die für die zweite Strahlung geeignet sind und eine Fabry-Perot-Resonatorausnehmung bilden, eine nicht von den zweiten Leuchtstoffen umgewandelte Strahlung blockieren und eine Durchlässigkeitsspitze für die zweite Strahlung aufweisen;
- Realisieren eines Spiegels (133) um die erste und die zweite Umwandlungsschicht (134G, 134R) herum, der sowohl die erste und die zweite Strahlung als auch die nicht von den ersten und den zweiten Leuchtstoffen umgewandelte Strahlung derart reflektiert, dass die erste und die zweite Umwandlungsschicht (134G, 134R) seitlich eingeschlossen werden.

**Claims**

1. Optoelectronic device (110G, 110R) comprising:

   - a LED suited to the emission of a radiation, the LED comprising an active layer (105), and
   - a conversion layer (134G, 134R) extending over the active layer (105) of the LED and comprising a plurality of fluorophores suited to the conversion of the radiation emitted by the LED,

   the conversion layer (134G, 134R) being confined laterally by a mirror (133) reflecting both a radiation converted by the fluorophores and the radiation not converted by the fluorophores, the device being **characterized in that** the conversion layer is confined vertically between a first multilayer reflective filter (131G, 131R) and a second multilayer reflective filter (132G, 132R) forming a resonant Fabry-Perot cavity that blocks the radiation not converted by the fluorophores and has a transmittance peak for the radiation converted by the fluorophores.

2. Optoelectronic device (110G, 110R) according to the preceding claim, wherein the fluorophores are nanophosphores.

3. Optoelectronic device (110G, 110R) according to the preceding claim, wherein the nanophosphores are selected from $SrSi_2O_2N_2:Eu^{2+;}$ $\beta$-SIALON; $Y_3Al_5O_{12}:Ce^{3+;}$ LuAG:Ce; $LuYAlMgSiO_3$:Ce; $SrSi_5N_8:Eu^{2+;}$ $(BaSr)_2Si_5N_8:Eu^{2+;}$ $(Ca, Sr)AlSiN_3:Eu^{2+;}$ $Sr[LiAl_3N_4]:Eu^{2+}$ ; $Sr[Mg_3SiN_4]:Eu^{2+;}$ $Sr_{1-x}Ca_xS:Eu^{2+}$.

4. Optoelectronic device (110G, 110R) according to claim 1, wherein the fluorophores are 3D quantum dots.

5. Optoelectronic device (110G, 110R) according to the preceding claim, wherein the 3D quantum dots are selected from: ZnS; ZnSe; CdS; CdSe; CdZnSe; CdTe; PbS; InP; $CuInS_2$; $CuGaS_{2;}$ $CuInSe_{2;}$ $CuGaSe_{2;}$ $CuInGaSe_{2;}$ CuSe; InSe; GaSe or any combination of the preceding alloys.

6. Optoelectronic device (110G, 110R) according to any of the preceding claims, wherein the radiation converted by the fluorophores is extracted from the resonant Fabry-Perot cavity by one of the first (131G, 131R) or second (132G, 132R) multilayer reflective filters, called "extraction filter", and in that said extraction filter comprises a grating for extracting (135G, 135R) the radiation converted by the fluorophores.

7. Optoelectronic device (110G, 110R) according to any of the preceding claims, wherein the first multilayer reflective filter (131G, 131R) extends between said active layer (105) and said conversion layer (134G, 134R) while the second multilayer reflective filter (132G, 132R) extends over the conversion layer (134G, 134R), and in that the second multilayer reflective filter (132G, 132R) has a reflectivity greater than 30% for the radiation converted by the fluorophores.

8. Pixel comprising a first optoelectronic device (110G) and a second optoelectronic device (110R) according to any of the preceding claims, the first optoelectronic device (110G) comprising a first LED and the second optoelectronic device (110R) comprising a second LED, the radiation converted by the fluorophores of the second LED being distinct from the radiation converted by the fluorophores of the first LED.

9. Pixel according to the preceding claim, further comprising a third LED (110B) for the emission of a radiation distinct from the radiations converted by the fluorophores of the first and second optoelectronic devices (110G, 110R).

10. Pixel according to the preceding claim, wherein the third LED (110B) has an active layer (105) confined laterally by a mirror and vertically between a first multilayer reflective filter and a second multilayer reflective filter forming a resonant Fabry-Perot cavity having a transmittance peak for the radiation emitted by the active layer.

11. Pixel according to the preceding claim, wherein the radiation emitted by the active layer is extracted from the resonant Fabry-Perot cavity by one of the first or multilayer reflective filters, called "extraction filter", and in that said extraction filter comprises a grating for extracting the radiation emitted by the active layer.

12. Method for manufacturing an optoelectronic device (110G, 110R) according to any of claims 1 to 7, comprising the following steps:

- producing a LED comprising an active layer (105);
- producing a first multilayer reflective filter (131G, 131R) above the active layer (105);
- producing a conversion layer (134G, 134R) comprising a plurality of fluorophores, configured to convert by fluorescence a radiation emitted by the active layer (105);
- producing a second multilayer reflective filter (132G, 132R), in such a way that the conversion layer (134G, 134R) is confined vertically between first (131G, 131R) and second (132G, 132R) multilayer reflective filters, the first and second multilayer reflective filters forming a resonant Fabry-Perot cavity, blocking the radiation not converted by the fluorophores and having a transmittance peak for a radiation converted by the fluorophores;
- producing around the conversion layer (134G, 134R) a mirror (133) reflecting both the radiation converted by the fluorophores and the radiation not converted by the fluorophores, so as to confine laterally the conversion layer (134G, 134R).

13. Method for manufacturing a pixel according to any of claims 8 to 11, comprising the following steps:

- producing first and second LEDs each comprising an active layer (105);
- producing a first multilayer reflective filter (131G), suited to a first radiation, above the active layer (105) of the first LED;
- producing a first multilayer reflective filter (131R), suited to a second radiation distinct from the first radiation, above the active layer (105) of the second LED;
- producing a first conversion layer (134G) comprising a plurality of first fluorophores, configured to convert by fluorescence a radiation emitted by the active layer (105) of the first LED so as to obtain the first radiation;
- producing a second conversion layer (134R) comprising a plurality of second fluorophores, configured to convert by fluorescence a radiation emitted by the active layer (105) of the second LED so as to obtain the second radiation;
- producing a second multilayer reflective filter (132G), suited to the first radiation, in such a way that the first conversion layer (134G) is confined vertically between the first and second multilayer reflective filters (131G, 132G) suited to the first radiation and forming a resonant Fabry-Perot cavity, blocking the radiation not converted by the first fluorophores and having a transmittance peak for the first radiation;
- producing a second multilayer reflective filter (132R), suited to the second radiation, in such a way that the second conversion layer (134R) is confined vertically between the first and second multilayer reflective filters (131R, 132R) suited to the second radiation and forming a resonant Fabry-Perot cavity, blocking the radiation not converted by the second fluorophores and having a transmittance peak for the second radiation;
- producing, around the first and around the second conversion layers (134G, 134R), a mirror (133) reflecting both the first and second radiations and the radiations not converted by the first and second fluorophores, so as to confine laterally the first and second conversion layers (134G, 134R).

**Fig.1**

Fig.2b

Fig.2a

Fig.3b

Fig.3c

Fig.3a

EP 3 699 967 B1

Fig.4a

Fig.4b

20

**Fig.5a**

**Fig.5b**

**Fig.5c**

EP 3 699 967 B1

**Fig.5d**

EP 3 699 967 B1

**Fig.5e**

**Fig.5f**

EP 3 699 967 B1

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20170250318 A

- EP 2750208 A

**Littérature non-brevet citée dans la description**

- **ROEL G. BAETS et al.** Resonant-cavity light-emitting diodes : a review. *Proc. of SPIE,* 2003, vol. 4996

- **GUAN-SYUN CHEN et al.** Monolithic red/green/blue micro-LEDs with HBR and DBR structures. *IEEE Photonics Technology Letters,* 01 Février 2018, vol. 30